# EUROPÄISCHE PATENTSCHRIFT

(11) **EP 1 022 849 B1**
(45) Veröffentlichungstag und Bekanntmachung des Hinweises auf die Patenterteilung: **22.12.2004**
(21) Anmeldenummer: 00101063.6
(22) Anmeldetag: 20.01.2000
(51) Int. Cl.: H03G 3/20, H04B 7/005, H04B 7/155, H04B 7/26

(54) **Vorrichtung zur Einstellung der Verstärkung eines Repeaters**
Device for setting the gain of a repeater
Dispositif de commande de gain d'un répéteur

(30) Priorität: 22.01.1999 DE 19902407
(43) Veröffentlichungstag der Anmeldung: 26.07.2000
(73) Patentinhaber: MIKOM GmbH, 86675 Buchdorf (DE)
(72) Erfinder: Schmidt, Karl-Heinz, 86753 Möttingen-Balgheim (DE)
(74) Vertreter: Tergau & Pohl Patentanwälte

(56) Entgegenhaltungen:
- WO-A-97/08854
- WO-A-97/33381
- US-A- 5 812 933

## Beschreibung

Die Erfindung bezieht sich auf eine Vorrichtung zur Einstellung der Verstärkung eines einen Downlink-Pfad und einen Uplink-Pfad aufweisenden Repeaters, vorzugsweise eines mobilen Repeaters, mit einer automatischen Pegelregelung, die bei Überschreiten eines Soll-Pegels im Downlink-Pfad simultan die Verstärkung im Downlink-Pfad und im Uplink-Pfad reduziert.

Ein derartiger Repeater wird insbesondere im Mobilfunkbereich eingesetzt und dient in einem entsprechenden Mobilfunksystem zur Versorgung von Funkteilnehmem, die in Folge hoher Dämpfung des hochfrequenten Signals nicht direkt von einer Basisstation erreicht werden können. Dazu weist der Repeater zwischen einem Anschluss für eine Anbindungsantenne und einem Anschluss für eine Versorgungsantenne zwei Verstärkergruppen auf, die als Downlink-Pfad und als Uplink-Pfad bezeichnet werden. Im Downlink-Pfad werden die über die Anbindungsantenne von der Basisstation empfangenen Signale gefiltert und verstärkt sowie anschließend über die Versorgungsantenne als verstärkte Sendesignale an die oder jede zu versorgende Mobilstation weitergeleitet. Analog dient der Uplink-Pfad zur Verstärkung der von der jeweiligen Mobilstation kommenden Signale und zu deren Weiterleitung an die Basisstation.

Der Repeater fügt den empfangenen Signalen üblicherweise keine Informationen hinzu, sondern leitet diese mit demselben Informationsgehalt oder -inhalt an die Mobil- bzw. Basisstation weiter. Um diese erforderliche Transparenz zwischen der Basisstation und der oder jeder Mobilstation zu gewährleisten, werden beide Vierstärkergruppen oder -pfade üblicherweise auf gleiche Verstärkung eingestellt. Die erhebliche Bedeutung der Transparenz ist darin begründet, dass der Rechner der Basisstation aus dem empfangenen Signalpegel auf die Streckendämpfung schließt und den Sendepegel der Mobilstation steuert. Dabei ist zu gewährleisten, dass einerseits eine Übersteuerung der Verstärker verhindert und andererseits ein maximaler Sendepegel nicht überschritten wird. Hierzu können in den Verstärkern oder Verstärker-Pfaden des Repeaters Schutzschaltungen vorgesehen sein, die das Ausgangssignal automatisch bei Übersteuerung auf einen maximalen Wert zurückregeln. Derartige Schutzschaltungen sind in der Nachrichtentechnik als automatische Pegelregelung bekannt und werden als Automatic Level Control (ALC) bezeichnet.

Zur Funkversorgung von Verkehrsmitteln, wie beispielsweise Eisenbahnzügen, werden ebenfalls Repeater eingesetzt. Während bei einem stationären Repeater die automatische Pegelregelung (ALC) im Downlink-Pfad bei korrekter Pegelung nicht anspricht, wird eine entsprechende Pegelregelung im Uplink-Pfad bei nahegelegenen Mobilstationen aktiv. Da sich bei einem beweglichen oder mobilen Repeater die Streckendämpfung zwischen der Basisstation und der Mobilstation ständig ändert, kann auch bei korrekter Pegelung eine Übersteuerung im Downlink auftreten. In einem solchen Fall wird die Pegelregelung im Downlink aktiv, wodurch die entsprechende Verstärkung reduziert wird. Dadurch wird jedoch das zuvor noch vorhandene Gleichgewicht der Verstärkung in beiden Richtungen gestört und die gewünschte Transparenz geht verloren.

Der Erfindung liegt daher die Aufgabe zugrunde, eine besonders geeignete Vorrichtung zur Einstellung der Verstärkung eines Repeaters, insbesondere eines mobilen Repeaters, anzugeben, mit welcher unter Vermeidung der genannten Nachteile eine Anpassung der Verstärkung in beiden Pfaden des Repeaters ermöglicht ist.

Diese Aufgabe wird erfindungsgemäß gelöst durch die Merkmale des Anspruchs 1. Vorteilhafte Ausgestaltungen sind Gegenstand der auf diesen rückbezogenen Unteransprüche.

Die Vorrichtung umfasst dazu zweckmäßigerweise einen Regelverstärker, der zunächst ein Steuersignal zur automatischen Pegelregelung im Downlink-Pfad erzeugt. Zur simultanen Einstellung auch der Verstärkung im Uplink-Pfad ist ein dort vorgesehenes Dämpfungsglied mit dem Regelverstärker z. B. über einen Steuerverstärker verbunden. Dabei kann das Dämpfungsglied an verschiedenen Stellen im zweckmäßigerweise aus mehreren Verstärkerstufen aufgebauten Uplink-Pfad angeordnet sein. So kann dieses Dämpfungsglied einem Endverstärker oder einer Endstufe unmittelbar oder über einen dieser wiederum vorgeordneten Verstärkerstufe vorgeschaltet sein. Bei der letztgenannten Alternative liegt das Dämpfungsglied dann praktisch im Eingang des Uplink-Pfades.

Die zur automatischen Pegeleinstellung oder Pegelregelung im Downlink-Pfad vorgesehene Regelschleife umfasst zweckmäßigerweise zusätzlich zum Regelverstärker und zum dort vorgesehenen (ersten) variablen Dämpfungsglied einen Detektor, der beispielsweise Teil einer Regelelektronik ist. Dieser Detektor überwacht das im Downlink-Pfad erzeugte Ausgangssignal im Hinblick auf einen überhöhten oder zu hohen Pegel. Aus dem Ergebnis dieser in Form eines Soll-Ist-Vergleichs durchgeführten Überwachung generiert der mit dem Detektor verbundene oder diesen enthaltende elektronische Regelverstärker die Stellgröße zur Ansteuerung des im Downlink-Pfad vorgesehenen Dämpfungsglieds. Diese Stellgröße wird dann simultan einer Verarbeitungseinrichtung in Form des Steuerverstärkers oder eines dem Regelverstärker nachgeschalteten Rechners zugeführt. Dieser kann ein separater Signalprozessor oder auch ein bei einem Repeater üblicherweise vorgesehenes Steuerteil sein. Die Verarbeitungseinrichtung steuert dann gleichzeitig das ebenfalls variable Dämpfungsglied im Uplink-Pfad an und stellt dort die Verstärkung gleichzeitig mit der Verstärkungseinstellung im Downlink-Pfad ein.

Die mit der Erfindung erzielten Vorteile bestehen insbesondere darin, dass bei Ansprechen der automatischen Pegelregelung im Downlink-Pfad gleichzeitig die Verstärkung im Uplink-Pfad eingestellt. Die Verstärkung im Uplink-Pfad wird hierbei zweckmäßigerweise derart reduziert, dass die Pegel im Downlink- und im Uplink-Pfad aneinander angepasst sind. Diese Pegelanpassung erfolgt insbesondere auch bei einem beweglichen Repeater automatisch.

Zweckmäßigerweise wird die automatische Pegelanpassung im Downlink-Pfad durch eine analoge oder digitale Regelschleife realisiert, in der entsprechende Regelgrößen generiert werden. Diese Regelgrößen werden zur Einstellung oder Steuerung der Dämpfung im Uplink-Pfad oder -Zweig herangezogen. Dabei werden die Dämpfungswerte sowohl im Downlink-Pfad als auch im Uplink-Pfad derart in Übereinstimmung gebracht, dass stets beide Dämpfungen gleich groß sind. Somit bleibt in besonders einfacher Art und Weise zuverlässig die Transparenz erhalten oder wird automatisch wieder hergestellt.

Die Verarbeitung der oder jeder Regelgröße zur automatischen Pegelanpassung erfolgt beispielsweise analog. Dabei wird eine im Regelkreis generierte Stellgröße einerseits zur Einstellung der Dämpfung im Downlink-Pfad herangezogen, so dass dessen gewünschter Ausgangspegel erhalten bleibt. Diese Stellgröße wird zudem simultan nun auch dazu verwendet, die Dämpfung im Uplink-Pfad derart einzustellen, dass dort die augenblickliche Gesamt-Verstärkung der Verstärkung im Downlink-Pfad entspricht. Die beschriebene Verarbeitung hinsichtlich der Dämpfungs- oder Verstärkungseinstellung sowie hinsichtlich der gesamten Signalverarbeitung im Downlink- und im Uplink-Pfad kann jedoch vorteilhafterweise auch digital, insbesondere mittels eines Controllers oder Signalprozessors, erfolgen. Dabei wird die Stellgröße für beide Pfade logisch verarbeitet und über Digital-Analog-Wandler (DAC) an entsprechende, digital steuerbare variable Dämpfungsglieder ausgegeben.

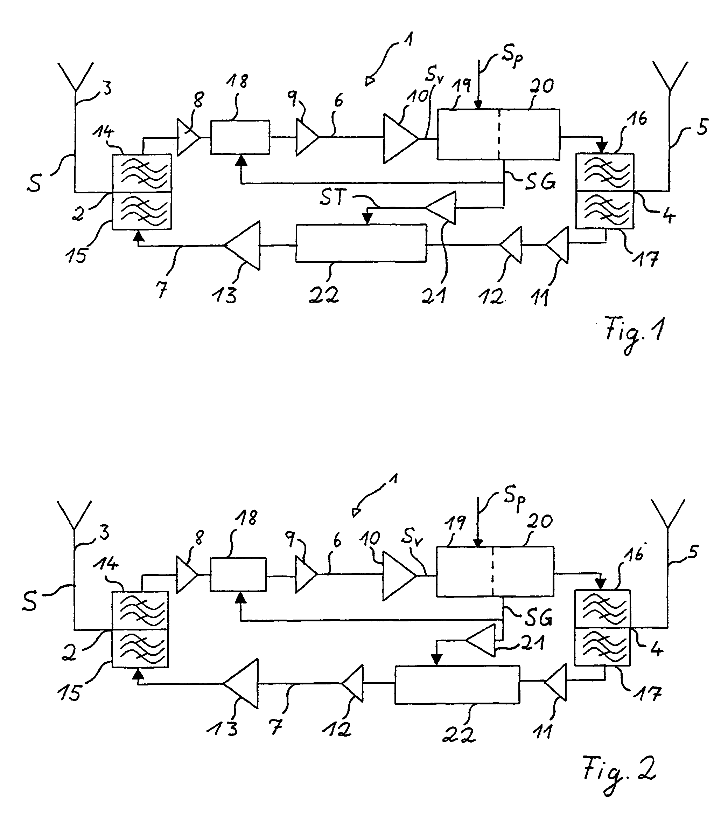

Nachfolgend werden Ausführungsbeispiele der Erfindung anhand einer Zeichnung näher erläutert. Darin zeigen die Figuren 1 bis 4 Blockschaltbilder eines Repeaters mit zur Verstärkungseinstellung oder automatischen Pegelanpassung vorgesehenen Komponenten.

Einander entsprechende Teile sind in allen Figuren mit den gleichen Bezugszeichen versehen.

Fig. 1 zeigt schematisch einen Repeater oder Repeater-Verstärker 1 mit einem ersten Anschluss 2, an den eine Anbindungsantenne 3 angeschlossen ist, und mit einem zweiten Anschluss 4, an den eine Versorgungsantenne 5 angeschlossen ist. Der Repeater 1 kommuniziert einerseits über die Anbindungsantenne 3 mit einer (nicht dargestellten) Basisstation und andererseits über die Versorgungsantenne 5 mit einer Anzahl von (nicht dargestellten) Mobilstationen. Der Weg von der Basisstation über den Repeater 1 zu der oder jeder Mobilstation wird als Down-Link bezeichnet, während der umgekehrte Weg als Up-Link bezeichnet wird.

Der beispielsweise von einem Schienenfahrzeug mitgeführte und somit bewegliche oder mobile Repeater 1 dient zur Verstärkung der von Basisstation ankommenden und an eine im Empfangsbereich des Repeaters 1 liegende Mobilstation weiterzuleitenden Signale sowie zur Verstärkung deren Signale an die Basisstation. Die in einem derartigen Mobilfunksystem gesendeten und empfangenen hochfrequenten Signale sind beispielsweise nach dem GSM-Standart (Global System for Mobil Communication) phasenmoduliert. Zur Verstärkung der von der Basisstation an die oder jede Mobilstation gesendeten Signale sowie zur Verstärkung der Signale in umgekehrter Richtung ist der Repeater 1 aus zwei parallelen Wegen aufgebaut, die als Downlink-Pfad 6 und als Uplink-Pfad 7 bezeichnet werden. Jeder Pfad 6,7 weist eine Anzahl von Verstärkerstufen 8 bis 10 bzw. 11 bis 13 auf.

Der Downlink-Pfad 6 ist eingangsseitig über eine Frequenzweiche 14 an den Anschluss 2 für die Anbindungsantenne 3 geführt. An diesen Anschluss 2 ist der Uplink-Pfad 7 ausgangsseitig ebenfalls über eine Frequenzweiche 15 geführt. Analog sind der Downlink-Pfad 6 ausgangsseitig über eine Frequenzweiche 16 und der Uplink-Pfad 7 eingangsseitig über eine weitere Frequenzweiche 17 an den Anschluss 4 für die Versorgungsantenne 5 geführt. Über diese Frequenzweichen 14 bis 17 im Bereich der Anschlüsse 2 und 4 ist die Parallelschaltung der beiden Pfade 6 und 7 des Repeaters 1 realisiert.

Im Downlink-Pfad 6 befindet sich ein erstes Dämpfungsglied 18, das im Ausführungsbeispiel zwischen die beiden Vorverstärkerstufen 8 und 9 geschaltet ist. Der dem Verstärker 9 nachgeordneten Endstufe (Endverstärker) 10 der Verstärkerschaltung ist eine einen Detektor 19 und einen Regelverstärker 20 aufweisende Regelanordnung oder -elektronik nachgeschaltet. Der Regelverstärker 20 ist ausgangsseitig mit dem variablen Dämpfungsglied 18 verbunden. Der Detektor 19 und der Regelverstärker 20 der Regelanordnung oder Regelelektronik bilden zusammen mit dem variablen Dämpfungsglied 18 einen Regelkreis zur automatischen Pegelregelung (ALC) im Downlink-Pfad 6.

Der Regelverstärker 20 ist außerdem ausgangsseitig über einen Steuerverstärker 21 mit einem zweiten variablen Dämpfungsglied 22 verbunden, das in den Uplink-Pfad 7 geschaltet ist. Während im Ausführungsbeispiel gemäß Fig. 1 dieses zweite Dämpfungsglied 22 zwischen den Endverstärker oder die Endstufe 13 und den oder jeden Vorverstärker 11,12 geschaltet ist, ist dieses im Ausführungsbeispiel gemäß Fig. 2 zwischen die beiden Vorverstärkerstufen 11,12 geschaltet. In dieser Ausführungsform, bei der der Repeater 1 ansonsten gemäß der Ausführungsform nach Fig. 1 aufgebaut ist, liegt somit das zweite Dämpfungsglied 22 am Eingang oder im Eingangsbereich des Uplink-Pfades 7.

Beim Betrieb des Repeaters gelangen die hochfrequenten Signale oder Eingangssignale S der Basisstation von der Anbindungsantenne 3 über die Frequenzweiche 13 auf die Verstärkerstufen 8 bis 10 im Downlink-Pfad 6. Die verstärkten Signale Sᵥ werden in der Regleranordnung oder Regelelektronik 19,20 hinsichtlich deren Signalpegel geprüft. Dazu überwacht der Detektor 19 die verstärkten Signale Sᵥ bezüglich einer Überschreitung eines maximalen Signalpegels. Dies erfolgt an Hand eines Soll-Ist-Vergleichs, wozu dem Detektor 19 ein Soll-Pegel Sp vorgegeben ist oder zugeführt wird. Aus einer Abweichung des Signalpegels von diesem Sollpegel S_{P} generiert der Regelverstärker 20 eine Stellgröße SG, die als Steuersignal dem variablen Dämpfungsglied 18 im Downlink-Pfad 6 zugeführt wird. Wird der maximal vorgegebene Pegel oder Sollpegel Sp überschritten, so wird das im Eingangsbereich oder an beliebiger Stelle des Downlink-Pfades 6 vorgesehene variable Dämpfungsglied 18 derart eingestellt oder angesteuert, dass der gewünschte Ausgangspegel des Downlink-Pfad 6 halten bleibt.

Diese im Regelkreis 19 bis 20 vorhandene Stellgröße SG wird über den Steuerverstärker 21 dem zweiten variablen Dämpfungsglied 22 im Uplink-Pfad 7 simultan als Steuersignal ST zugeführt. Dabei wird das Dämpfungsglied 22 derart eingestellt oder angesteuert, dass die momentane Gesamt-Verstärkung im Uplink-Pfad 7 der Verstärkung des Downlink-Pfades 6 entspricht. Auf diese besonders effektive Art und Weise erfolgt eine automatische Pegelanpassung der beiden Pfade 6,7 des Repeaters 1 aneinander, wobei die Verarbeitung der Stellgröße SG analog erfolgt.

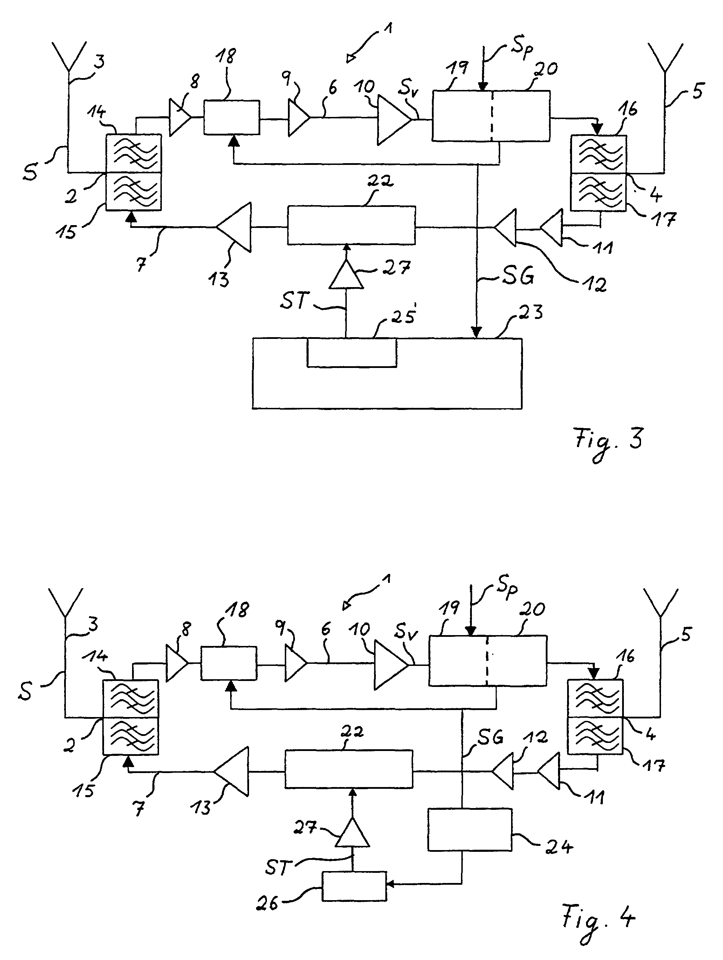

Alternativ kann die Verarbeitung der Regelgrößen des Regelkreises 19 bis 20 und damit die Verarbeitung der Stellgröße SG auch digital erfolgen. Dazu ist gemäß den Figuren 3 und 4 eine Verarbeitungseinrichtung 23 bzw. 24 vorgesehen. Diese ist im Ausführungsbeispiel gemäß Fig. 3 zweckmäßigerweise das Steuerteil des ansonsten wiederum gleichartig aufgebauten Repeaters 1. Die Verarbeitungseinrichtung in Form des Steuerteils 23 bzw. des Rechners 24 nach Fig. 4, der beispielsweise ein Controller oder ein Signalprozessor ist, liest die Stellgröße SG ein. Die mittels des Steuerteils 23 bzw. des Signalprozessors oder Rechners 24 logisch verarbeitete Stellgröße SG wird dem zweiten Dämpfungsglied 22 über einen Digital/Analog-Wandler 25 bzw. 26 als Steuersignal ST ausgegeben. Dieser steuert dann das zweite Dämpfungsglied 22 direkt oder über einen Steuerverstärker 27 an. Bei direkter Ansteuerung entfällt somit der Steuerverstärker 27.

In einer weiteren zweckmäßigen Weiterbildung kann das erste Dämpfungsglied 18 im Downlink-Pfad 6 auch digital eingestellt werden, so dass dann die gesamte Signalverarbeitung in einem Rechner, z. B. in einem Controller oder Signalprozessor, erfolgt.

Bei allen Ausführungsformen wird mittels dieses Verfahrens die Verstärkung im Downlink-Pfad 6 und im Uplink-Pfad 7 derart eingestellt, dass eine automatische Verstärkungs-Anpassung oder automatische Pegelanpassung in beiden Pfaden 6 und 7 erfolgt. Dazu wird insbesondere die Verstärkung im Uplink-Pfad 7 beim Ansprechen der durch das erste Dämpfungsglied 18 sowie den Detektor 19 und den Regelverstärker 20 gebildeten automatischen Pegelregelung (ALC) des Downlink-Pfad 6 reduziert. Diese automatische Pegelregelung des Downlink-Pfad 6 kann dabei durch eine analoge oder digitale Regelschleife realisiert sein. Die dort anzutreffenden Regelgrößen werden genutzt, um das zweite Dämpfungsglied 22 im Uplink-Zweig 7 derart einzustellen oder anzusteuern, dass die Dämpfungswerte im Downlink-Pfad 6 und die Dämpfungswerte im Uplink-Pfad aneinander angepasst oder in Gleichlauf gebracht werden. Somit ist sichergestellt, dass in beiden Pfaden 6 und 7 die Dämpfungen stets gleich groß sind. Dadurch wird die eingangs erwähnte Transparenz zwischen der Basisstation und der oder jeder Mobilstation automatisch wiederhergestellt, wenn beispielsweise aufgrund des sich bewegenden Repeaters 1 das Gleichgewicht der Verstärkung in beiden Richtungen, d. h. über den Downlink-Pfad 6 einerseits und den Uplink-Pfad 7 andererseits, gestört worden ist.

### Bezugszeichenliste

- 1: Repeater
- 2: Anschluss
- 3: Anbindungsantenne
- 4: Anschluss
- 5: Versorgungsantenne
- 6: Downlink-Pfad
- 7: Uplink-Pfad
- 8-10: Verstärkerstufe
- 11-13: Verstärkerstufe
- 14-17: Frequenzweiche
- 18: (erstes) Dämpfungsglied
- 19: Detektor
- 20: Regelverstärker
- 21: Steuerverstärker
- 22: (zweites) Dämpfungsglied
- 23: Steuerteil
- 24: Rechner
- 25,26: Digital/Analog-Wandler
- 27: Steuerverstärker

## Patentansprüche

1. Vorrichtung zur Einstellung der Verstärkung eines einen Downlink-Pfad (6) und einen Uplink-Pfad (7) aufweisenden Repeaters (1), vorzugsweise eines mobilen Repeaters, mit einer automatischen Pegelregelung (18,19,20), die bei Überschreiten eines Soll-Pegels (Sp) im Downlink-Pfad (6) simultan die Verstärkung im Downlink-Pfad (6) und im Uplink-Pfad (7) reduziert,
**gekennzeichnet durch**,
einen zusammen mit einem Regelverstärker (20) und mit einem im Downlink-Pfad (6) angeordneten ersten Dämpfungsglied (18) einen Regelkreis bildenden Detektor (19), der ein im Downlink-Pfad (6) erzeugtes Ausgangssignal (Sᵥ) empfängt und dessen Pegel überwacht, wobei eine vom Regelverstärker (20) generierte Stellgröße (SG) simultan dem ersten Dämpfungsglied (18) und einer Verarbeitungseinrichtung (21,23,24) zugeführt ist, die ein im Uplink-Pfad (7) angeordnetes zweites Dämpfungsglied (22) mittels eines Steuersignals (ST) derart einstellt, dass die Verstärkung im Uplink-Pfad (7) der Verstärkung im Downlink-Pfad (6) entspricht.

2. Vorrichtung nach Anspruch 1,
**dadurch gekennzeichnet,**
**dass** der Uplink-Pfad (7) eine Anzahl von Verstärkerstufen (11,12,13) aufweist, wobei das zweite Dämpfungsglied (22) im Uplink-Pfad (7) der Endstufe (13) vorgeschaltet ist.

3. Vorrichtung nach Anspruch 1 oder 2,
**dadurch gekennzeichnet,**
**dass** dem Regelverstärker (20) ein Steuerverstärker (21) nachgeschaltet ist, der aus der Stellgröße (SG) das Steuersignal (ST) für das zweite Dämpfungsglied (22) erzeugt.

4. Vorrichtung nach einem der Ansprüche 1 bis 3,
**gekennzeichnet durch**,
einen dem Regelverstärker (20) nachgeschalteten Rechner (23,24), der die Stellgröße (SG) logisch verarbeitet und dem zweiten Dämpfungsglied (22) über einen Analog/Digital-Wandler (25,26) als Stellgröße (ST) zuführt.

5. Vorrichtung nach Anspruch 4,
**dadurch gekennzeichnet,**
**dass** der Rechner ein Steuerteil (23) des Repeaters (1) ist.

## Claims

1. Apparatus for setting the gain of a repeater (1) which has a downlink path (6) and an uplink path (7), preferably of a mobile repeater, having automatic level control (18, 19, 20) which simultaneously reduces the gain in the downlink path (6) and in the uplink path (7) if a nominal level (Sp) is exceeded in the downlink path (6),
**characterized by**
a detector (19) which, together with a control amplifier (20) and with a first attenuator (18) arranged in the downlink path (6), forms a control loop, receives an output signal (Sᵥ) produced in the downlink path (6) and monitors its level, with a manipulated variable (SG), which is generated by the control amplifier (20), being supplied simultaneously to the first attenuator (18) and to a processing device (21, 23, 24), which sets a second attenuator (22), arranged in the uplink path (7), by means of a control signal (ST) such that the gain in the uplink path (7) corresponds to the gain in the downlink path (6).

2. Apparatus according to Claim 1,
**characterized**
**in that** the uplink path (7) has a number of amplifier stages (11, 12, 13), with the second attenuator (22) being connected upstream of the output stage (13) in the uplink path (7).

3. Apparatus according to Claim 1 or 2,
**characterized**
**in that** a control amplifier (21) is connected downstream from the control amplifier (20) and uses the manipulated variable (SG) to produce the control signal (ST) for the second attenuator (22).

4. Apparatus according to one of Claims 1 to 3,
**characterized by**
a computer (23, 24) which is connected downstream from the control amplifier (20), logically processes the manipulated variable (SG), and supplies it as the manipulated variable (ST) to the second attenuator (22) via an analogue/digital converter (25, 26).

5. Apparatus according to Claim 4,
**characterized**
**in that** the computer is a control part (23) of the repeater (1).

## Revendications

1. Dispositif pour le réglage de l'amplification d'un répéteur (1), qui possède une voie (6) de liaison downlink, c'est-à-dire de liaison dans le sens descendant, et une voie (7) de liaison uplink, c'est-à-dire de liaison dans le sens montant, de préférence un répéteur mobile, comportant une unité de régulation automatique de niveau (18, 19, 20), qui lors du dépassement d'un niveau de consigne (Sₚ) dans la voie downlink (6) réduit simultanément l'amplification dans la voie downlink (6) et dans la voie uplink (7), **caractérisé par**
un premier détecteur (19), qui forme un circuit de régulation conjointement avec un amplificateur de régulation (20) et un premier circuit d'amortissement (18) disposé dans la voie downlink (6) et qui reçoit un signal de sortie (Sᵥ) produit dans la voie downlink (6) et contrôle son niveau, une grandeur de réglage (SG) générée par l'amplificateur de réglage (20) étant envoyée simultanément au premier circuit d'amortissement (18) et à un dispositif de traitement (21,23,24) et qui règle un second circuit d'amortissement (22) disposé dans la voie uplink (7) de telle sorte que l'amplification dans la voie uplink (7) correspond à l'amplification dans la voie downlink (6).

2. Dispositif selon la revendication 1, **caractérisé en ce**
**que** la voie uplink (7) comporte un nombre d'étages amplificateurs (11,12,13), le second circuit d'amortissement (22) dans la voie uplink (7) étant branché en amont de l'étage final (13).

3. Dispositif selon la revendication 1 ou 2, **caractérisé en ce**
**qu'**en aval de l'amplificateur de régulation (20) est branché un amplificateur de commande (21) qui, à partir de la grandeur de réglage (SG), produit le signal de commande (ST) pour le second organe d'amortissement (22).

4. Dispositif selon l'une des revendications 1 à 3, **caractérisé par**
un calculateur (23,24), qui est branché en aval de l'amplificateur de régulation (20) et qui traite logiquement la grandeur de réglage (SG) et l'envoie en tant que grandeur de réglage (ST) au second circuit d'amortissement (22) par l'intermédiaire d'un convertisseur analogique/numérique (25,26) .

5. Dispositif selon la revendication 4, **caractérisé en ce que** le calculateur est une partie de commande (23) du répéteur (1).
